# EUROPEAN PATENT SPECIFICATION

(11) **EP 2 276 057 B1**
(45) Date of publication and mention of the grant of the patent: **02.11.2011**
(21) Application number: 09400026.2
(22) Date of filing: 29.05.2009
(51) Int. Cl.: H01L 21/00

(54) **In-line gas-phase diffusion furnace**
Linearer Gasphasen-Diffusionsofen
Four à diffusion de phase gazeuse en ligne

(43) Date of publication of application: 19.01.2011
(73) Proprietor: Roth & Rau AG, 09337 Hohenstein-Ernstthal (DE)
(72) Inventor: Scheit, Uwe, Dr., 15232 Frankfurt/Oder (DE)
(74) Representative: Steiniger, Carmen

(56) References cited:
- WO-A-93/17448
- JP-A- 2004 163 020
- US-A- 4 803 948
- US-B1- 6 251 756

## Description

The present invention relates to a diffusion furnace, and particularly to an in-line diffusion furnace employing vapor phase dopant, especially for solar cell applications, and to a method for doping substrates, and particularly to a method for doping substrates in an in-line diffusion furnace using vapor phase dopant, especially for solar cell applications.

Furnaces of the said category are known from prior art. The document US 6,251,756 B1 describes a batch furnace for gas phase doping wherein separate quartz tubes are attached in a linear arrangement of several zones for thermal treatment and gas phase doping of batches of substrates. Furnaces of this type have huge mechanical dimensions and could not establish in industry until now.

Especially for wafer-processing in the electronics industry, single wafer chambers are established. WO 93 17448 discloses a single wafer chamber for gas phase doping and a relating method. Single wafer chambers are sophisticated solutions with high flexibility for instance for research usage. For the mass production of solar cells, the costs for single wafer chambers are too high.

A solution for production tools with low cost of ownership are in-line furnaces. A furnace of this type is described in JP 2004 163020 A. These in-line furnaces are used for instance for thermal treatment or to diffuse a dopant from a solid coating on the substrates into the substrate.

Solar cells typically comprise pn-junctions in semiconductor substrates, achieved by means of a diffusion process. The diffusion process can occur from a dopant vapor ambient, for example, phosphine or POCl₃, or from solid source releasing dopant vapor. Another process can employ a dopant layer coated on the substrate, which, upon heating or firing, causes the dopant to diffuse from the dopant layer into the substrate

In-line doping diffusion process is a preferred process. In a typical in-line diffusion process, the substrate is coated with a phosphorus containing dopant and subsequently, the phosphorus from the dopant layer is diffused into the substrate in a furnace.

The coating of the phosphorus source can be accomplished by spraying, dipping, spin-on, rolling or condensation of a phosphorus-containing chemical, in liquid or gaseous form, with or without solvent, and with or without carrier gas.

Solar-cell applications tend to structures with high-resistance emitters. As a consequence in typical in-line doping processes emitters with flat diffusion profiles are produced. Unfortunately, contacting of such emitters is relatively difficult.

It is the object of the present invention to provide an in-line diffusion furnace and a method for doping substrates in said in-line diffusion furnace with a high efficiency, a high homogeneity and an optimized doping profile of the substrates. In particular, a diffusion furnace and a corresponding method for doping allowing a formation of deep but high-resistance diffusion profiles shall be provided.
In an embodiment of the present invention, the object is solved by an in-line diffusion furnace for gas phase doping substrates, comprising: a diffusion chamber; a heater assembly to form a hot zone; a transport assembly for continuously transport a plurality of substrates through the hot zone; and a dopant delivery assembly for delivering a vapor dopant precursor to the hot zone, allowing diffusion of the vapor dopant precursor to the substrates, wherein the dopant delivery assembly comprises means forming a locally defined area in a diffusion area of the diffusion chamber with a defined atmosphere.

Advantages of the present continuous furnace include simplified equipment with high throughput and simplified substrate surface preparation since a wettable surface is not required. The present in-line furnace comprises a continuous transport mechanism for transferring the substrate from a loading station to a diffusion furnace station and then to an unloading station. The transport mechanism can comprise transport rollers, such as ceramic rollers, transport belt, such as metal belt, and transport wires, such as walking wires.

The in-line diffusion furnace further comprises a hot zone, or a plurality of hot zones to provide a desired temperature profile for the heating of the substrates traveling through the hot zones. The length of the hot zones is designed to achieve the desired doping profile, accounting for the transport speed of the substrate through the hot zones. The temperature profile of the hot zones is designed to optimize the dopant diffusion process, for example, a ramping up section, a steady state section, and a cooling down section.

The present in-line furnace further comprises a gas-phase dopant delivery system to deliver vapor or gaseous dopant to the hot furnace zone. The dopant materials can comprise boron, phosphorus and arsenic chemistry to form a doped area within the substrate. In an aspect, the dopant comprises phosphorus acid or any derivatives of phosphorus acid. The dopant delivery system provides gaseous dopant to the hot furnace, forming gaseous dopant interface with the surface of the substrates, and allowing dopant to diffuse into the substrates.

Since the dopant delivery assembly comprises means forming a locally defined area in a diffusion area of the diffusion chamber, a defined atmosphere can be formed in said locally defined area. The locally defined area can be formed above, under or around the substrates. The defined atmosphere can be formed with a defined temperature or a defined temperature profile, with a defined dopant concentration or dopant concentration profile and with or without one or more further precursors. By the formation of a defined atmosphere in the locally defined area inside the diffusion chamber, the conditions for diffusion are very well controllable. The substrates moved continuously through said locally defined area are all treated equally, resulting in a high homogeneity of the dopant profiles formed in the substrates and a high throughput of substrates through the in-line furnace of the present invention.

In an aspect, the dopant delivery system comprises a showerhead, positioned substantially parallel to the substrate's surface at a minimum distance. The close distance between the showerhead and the substrates allows a small dopant environment, increasing the dopant uniformity with a small volume of dopant chemical surrounding the substrates. The dopant showerhead can be positioned in the hot zone furnace, with or without an active heater to maintain a desired temperature. The dopant showerhead can form the hot zone furnace, with the furnace heater located outside or inside the showerhead. A plurality of showerheads can be positioned next to each other. The length of the showerhead and the number of the showerheads can determine the throughput of the in-line diffusion furnace, affecting the speed of the transport system. The width of the showerhead is preferably similar to the width of the furnace, determining the number of substrates that can be transported in parallel. Alternatively, a number of showerheads can be positioned along the width of the furnace. The showerhead system can deliver vapor dopant to one surface, or to both surfaces of the substrates, for example, comprising a top showerhead and a bottom showerhead. In an aspect, the dopant delivery system comprises a nozzle delivering the dopant to the hot zone furnace, and/or comprises an enclosure within the hot zones, capturing the dopant for delivery to the surface of the substrates.
In another embodiment of the present invention, the means forming a locally defined area in a diffusion area of the diffusion chamber with a defined atmosphere comprises an internal enclosure in the diffusion chamber.

In an embodiment, the present in-line furnace comprises dopant isolation assembly, surrounding the dopant hot zones of the furnace to minimize releasing dopant chemicals to the outside ambient. The dopant isolation assembly comprises a purging and an exhaust, or any combination of exhaust and purging, for example, a purging gas surrounded by vacuum exhaust. The dopant isolation assembly can be positioned at the loading and unloading stations of the in-line furnace, for example, allowing entrance and exit of the substrates and limiting the release of dopant to the outside. In an aspect, the dopant isolation assembly can be positioned on the sides of the furnace, preventing dopant chemicals from escaping to the sides of the furnace. For example, for roller transport system, the rollers can protruded outside the hot zone furnace, thus the hot zone furnace can communicate with the outside ambient through the opening of rollers. Dopant isolation at these roller openings can limit the release of dopant chemicals. In addition, furnace cover and exhaust can be provided to further limit the escape of dopant chemicals.

In an embodiment, the present in-line furnace comprises a temperature insulation assembly, surrounding the dopant hot zones of the furnace to minimize fluctuation of temperature profile, and to provide a uniform temperature profile within the hot zones. The temperature insulation can comprise passive insulation materials such as ceramic fiber insulation, and active temperature compensation at the boundaries of the hot zones. In an aspect, the temperature insulation assembly can be positioned on the sides of the furnace, ensuring temperature uniformity along the width of the furnace hot zones. For example, for a roller transport system, the rollers can protrude outside the hot zone furnace, thus the high temperature of the hot zone furnace can leak to the outside ambient through the opening of rollers. Temperature insulation comprising insulation material at the hot zone boundaries and heaters located inside and/or outside the insulation material can compensate for the low temperature outside ambient.

In an embodiment, the present invention comprises a dopant chemistry to form a doping region in the substrate, together with an oxygen chemistry to form an oxide layer on the substrate. Under the high temperature of the hot zone furnace, the dopant chemistry diffuses to the semiconductor substrate (or to a semiconductor layer on a substrate) to form a doping region, and the oxygen chemistry reacts with the substrate to grow an oxide layer on the surface. For example, the present dopant chemistry can comprise a mixture of phosphorus-containing chemical and oxygen-containing chemical where the phosphorus forms a doping region and the oxygen oxidizes the substrate surface. The present dopant/oxygen mixture can be utilized in the in-line, continuous diffusion furnace to simultaneously dope and oxidize the substrates passing through the furnace hot zones.

In the following, exemplary embodiments of the present invention will be explained with reference to the drawings in more detail, wherein:
Fig. 1 illustrates an exemplary in-line diffusion furnace for continuous doping substrates.
Fig. 2 illustrates another exemplary in-line diffusion furnace for continuous doping substrates.
Fig. 3 illustrates an exemplary in-line diffusion furnace employing showerhead dopant delivery.
Fig. 4 illustrates an exemplary in-line diffusion furnace employing dopant enclosure.
Fig. 5 illustrates an exemplary in-line diffusion furnace with multiple hot zones.
Fig. 6 illustrates an exemplary temperature profile for the furnace.
Fig. 7 illustrates an exemplary interface of the transport rollers with the furnace walls.
Fig. 8 illustrates an exemplary active temperature compensation at the wall of the furnace hot zone.
Fig. 9 illustrates an exemplary dopant isolation assembly at the wall of the furnace doping zone.
Fig. 10 illustrates an exemplary dopant isolation assembly at the entrance of the furnace.
Fig. 11 illustrates an exemplary flowchart for an embodiment of the present in-line continuous vapor phase diffusion furnace.
Fig. 12 illustrates an exemplary flowchart for an embodiment of the present in-line continuous vapor phase diffusion furnace employing doping/oxidizing precursor.
Fig. 13 illustrates another exemplary flowchart for an embodiment of the present in-line continuous vapor phase diffusion furnace employing doping/oxidizing precursor.

The present invention relates to methods and a system of in-line diffusion of dopant precursor onto a semiconductor substrate (or a semiconductor layer on a substrate) for forming an electrical pn-junction. The present invention further pertains to the manufacture of photovoltaic cells, forming an in-line diffusion furnace for producing photovoltaic junctions. In an embodiment, the present invention forms a dopant layer on a substrate, by subjecting the substrate to a vapor phase dopant in a hot zone. The dopant layer can be formed by a continuous application of a dopant source material in a gaseous form to the substrate. The substrate is preferably a single crystal or multicrystalline (or polycrystalline) silicon substrate, but other substrates, such as glass or metal substrates, or substrates with a semiconductor coating, can also be utilized. The present invention can provide high performance junctions for cost reduction and productivity improvement in photovoltaic cells and related devices.

In an embodiment, the substrate is exposed to a gaseous ambient of dopant material at high temperature in an atmospheric continuous diffusion furnace. The dopant material can comprise phosphorus, arsenic, or boron, such as phosphine (PH₃), POCl₃, or phosphorous acid (H₃PO₄). The diffusion temperature can be between 600°C and 1100°C.

In an embodiment, the present invention discloses a vapor diffusion process in a continuous in-line diffusion process, offering simplified equipment with high throughput. In an aspect, substrates are continuously transported through a hot zone containing a dopant ambient. The high temperature of the dopant ambient drives the dopant onto the substrate to form the doping layer. The drive time is determined by the length of the furnace and the speed of the substrate transport.

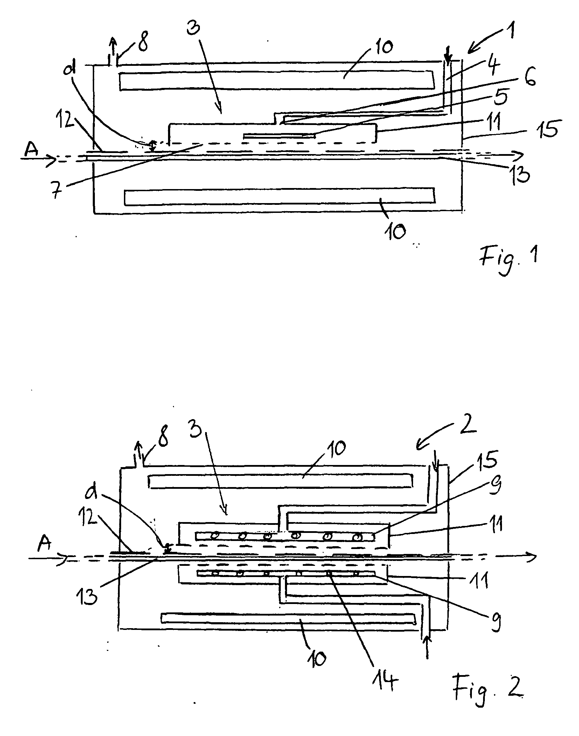

Fig. 1 schematically illustrates a furnace 1 according to an exemplary embodiment of the present invention, comprising a diffusion chamber 15 with a dopant ambient within a hot zone 3 established by heaters 10 to be diffused to a plurality of substrates 12, which are continuously transported through the hot zone 3 by a transport assembly 13. The substrate 12 can be a round single crystal silicon wafer, or a square multicrystalline silicon wafer, or a glass or metal panel with a semiconductor coating. The dopant ambient is formed by a vapor dopant source, comprising the appropriate dopant for forming a pn-junction with the substrate 12. In the embodiment shown in Fig. 1, the dopant ambient is formed on and around the substrates 12 by a showerhead 11 arranged above the transport assembly 13.

The showerhead 11 is connected by at least one inlet 4 with a dopant delivery assembly placed in or outside the furnace 1. In the example shown, the showerhead 11 includes at least one baffle plate 5 placed opposite to an inlet opening 6 for a defined distribution of the dopant inside the showerhead 11. Dependent on the number, the size and the dimensions of the at least one baffle plate 5, a homogeneous as well as a characteristic profile of the dopant distribution can be adjusted. In other, not shown embodiments of the present invention the at least one baffle plate 5 can also be omitted.

The showerhead 11 further comprises a plurality of openings 7 such as holes or slits in its side opposite to the substrates 12. The openings 7 can be formed by drilling, sawing, slitting or cutting or can be originally formed in the material of the showerhead 11, for instance by using a showerhead 11 of a porous material such as a sintered material.

Between the showerhead 11 and the surface of the substrates 12 is a minimum distance d. A minimum distance d means in accordance with the present invention that the dopant ambient provided by the showerhead 11 can be transferred directly onto the substrates 12 transported continuously under the showerhead 11. That means, said distance d is big enough to allow an unhindered substrate transport, but also small enough to provide a defined dopant atmosphere under the showerhead 11.

The furnace 1 further comprises at least one exhaust 8 for an exhaustion of the residual gases and reaction products and for a continuous discharge flow through the furnace 1.

Fig. 2 schematically illustrates another furnace 2 according to another exemplary embodiment of the present invention where the substrates 12 can be doped simultaneously at both sides through a dopant ambient formed in a diffusion chamber 15 by showerheads 11 provided at both front and back sides of the substrates 12. The diffusion hot zone 3 can be enclosed in a chamber of the furnace 2 made of quartz or glass, together with temperature insulation material.

Each of the showerheads 11 has, similar like the showerhead 11 of Fig. 1, a plurality of openings 7 such as holes or slits in its side opposite to the substrates 12. The showerheads 11 are provided in the furnace 2 in such a way that their openings 7 are opposite to each other and facing the front and the back sides of the substrates 12, respectively.

In the embodiment of Fig. 2, the dopant ambient is provided by the showerheads 11 each having, instead of the baffle 5 in the embodiment of Fig. 1, internal tubes 9 with openings 14 providing a defined dopant distribution in the respective showerhead 11 and, thereby, also on the substrates 12 transported through the gap between the showerheads 11. The openings 14 of the internal tubes 9 can be provided with a same or with a different distance to provide a defined dopant distribution profile in the showerheads 11.

The gap between the showerheads 11 and the surface of the substrates 12 is very small. Thus, the dopant ambient provided by the showerheads 11 can be transferred directly onto the substrates 12 transported continuously through the gap between the showerheads 11. The gap shall be big enough to allow an unhindered substrate transport, but also small enough to provide a defined dopant atmosphere between the showerheads 11.

Although in the examples shown in Figs. 1 and 2 along the direction A of transportation of the substrates 12 through the hot zone 3 only one or two opposite showerheads 11 are provided, in other embodiments of the present invention more showerheads 11 can be provided. The showerheads 11 can be arranged consecutively at different places in the furnace 1, 2 allowing successive effect of different dopant ambients, such as different dopant substances, on the substrates 12. Consecutively, arranged showerheads 11 can also be used to increase the diffusion time for the continuously moving substrates 12. The showerheads 11 can also be arranged in parallel, such as in several parallel traces to achieve a high throughput and a better homogeneity over the width of the furnace 1, 2 during doping. In the latter example, the showerheads 11 can be arranged in parallel over particular traces or over a group of particular traces.

In an embodiment, the dopant material is phosphorus, for example, from a phosphorus acid containing precursor. In this specification, the term phosphorus acid containing precursor includes a mixture of phosphorus acid or any variant of phosphorus acid, such as hypophosphorous acid (H₃PO₂), phosphorous acid (H₃PO₃), phosphoric acid (H₃PO₄), peroxomonophosphoric acid (H₃PO₅), hypophosphoric acid (H₄P₂O₆), pyrophosphoric acid (H₄P₂O₇), metaphosphoric acid (HPO₃), or triphosphoric acid (H₅P₃O₁₀). In an aspect, phosphorus acid is vaporized and the vapors delivered to the hot zone of the diffusion furnace. The diffusion process can be at atmospheric pressure, or sub-atmospheric pressure to aid in confining the vapor. The diffusion area can comprise an exhaust or a hood to prevent any phosphorus acid vapor from escaping.

Phosphorus acid may be vaporized by heating phosphorus acid to its boiling point, and preferably to a temperature higher than the boiling temperature to ensure complete vaporization of the phosphorus acid. A heated vessel can be used to heat the liquid phosphorus acid. Alternatively, phosphorus acid can be sprayed, for example, with an atomizer or an ultrasonic spray, and with or without a gas carrier, through a heated zone. The gas carrier can be an inert gas, a non-reactive gas, or a reactive gas.

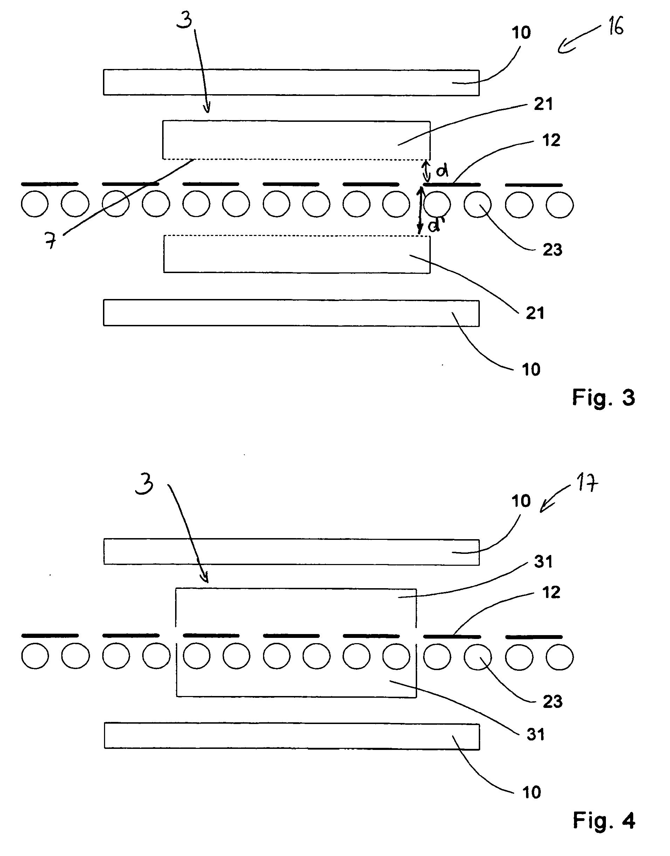

Fig. 3 illustrates schematically a preferred embodiment of the present in-line diffusion furnace 16, comprising one or more showerheads 21 facing the substrates 12 in a hot diffusion zone 3 to deliver a dopant precursor to the substrates 12. The substrates 12 are transported continuously through the hot zone 3 by a transport mechanism, such as a number of ceramic rollers 23. Other continuous transport mechanism can also be used, such as continuous belt or walking wires. The substrates 12 are preferably positioned substantially horizontal or at an angle on the transport assembly. The showerheads 21 can be positioned on top of the substrates 12 for front side doping, at the bottom of the substrates 12 for backside doping, and at both sides for simultaneous doping of both sides of the substrates 12. The showerhead 21 is positioned at a small distance d, d' from the corresponding surface of the substrates 12, thus generating a small, locally defined area in the diffusion area of the diffusion chamber with a defined doping environment or doping atmosphere for effective doping.

The showerhead 21 has a number of openings 7 such as holes or slots to deliver dopant precursor onto the substrates 12, which can be fabricated by drilling, slitting, sawing or cutting, or by using a porous materials such as a sintered material.

The plurality of showerheads 21 can be positioned along the width and along the length of the furnace 16, for adequate processing time. The showerheads 21 can enable the vapor phase doping of the moving substrates 12, providing a controllable dopant ambient for diffusing the dopant into the substrates 12. The showerheads 21 can be positioned in the hot diffusion zone 3, established by a number of heaters 10, such as resistive or radiative heaters. Alternatively, the heaters 10 can be embedded in the showerheads 21. Vapor dopant precursor can be introduced to the showerheads 21 (not shown), for example, through a precursor delivery system such as a heater to vaporize liquid or solid precursor, or a heater to heat up gaseous precursor. The showerheads 21 can include baffles (as shown in Fig. 1) to ensure uniform delivery of precursor at the showerhead outlets. The dopant precursor can comprise carrier gas such as inert gas or inactive gas.

Fig. 4 illustrates another exemplary embodiment of the present in-line diffusion furnace 17, employing enclosures 31 within the hot diffusion zone 3 to delivery dopant precursor to the substrates 12. The enclosures 31 cover the substrates 12 from the top and the bottom, leaving only a small gap through which the substrates 12 travel. For example, the substrates 12 can be transported by a number of rollers 23, and the bottom enclosure 31 can be positioned between the gaps of the rollers 23, effectively forming a dopant environment with minimum communication with the outside area.

The length of the in-line diffusion furnace 17 is designed to accommodate a desired throughput, in conjunction with the speed of the transport assembly.

In an embodiment, the present diffusion furnace further comprises substrate loading and unloading stations. In addition, the hot diffusion zone 3 can comprise a temperature ramp up station, a temperature steady state station and a cool down station.

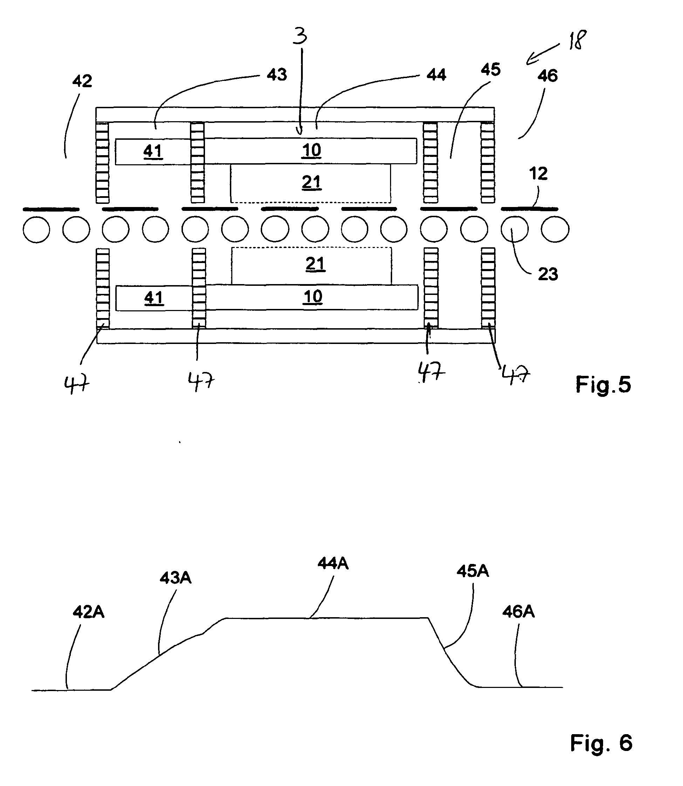

Fig. 5 illustrates an exemplary diffusion furnace 18, comprising a roller transport assembly 23 for transporting a plurality of substrates 12. The furnace 18 comprises a loading station 42 for loading substrates 12, preferably maintained at room temperature, and shown without an enclosure. The furnace 18 also comprises an unloading station 46 for unloading substrates 12, also preferably maintained at room temperature, and shown without an enclosure. The hot zone 3 of the diffusion furnace can comprise a ramp up station 43, a steady state station 44 and a cool down station 45. The stations 43, 44, 45 are preferably separated by insulation means 47, but there might not be any separation in some furnace designs.

The temperature ramp up station 43 can comprise heater 41 for maintaining a temperature, preferably less than the diffusion temperature. The temperature of the substrates 12 entering the ramp up station 43 can increase to a predetermined value before entering the diffusion zone. The steady state station 44 can comprise heater 10 to maintain the zone at the diffusion temperature, rapidly increasing the temperature of the substrates 12 to the desired processed temperature. Also in this high temperature diffusion zone, the dopant precursor is delivered to the moving substrates 12, for example, through the showerheads 21 for doping both the top and bottom of the substrates 12. A number of showerheads 21 can be included to ensure a desired throughput. The cool down station 45 can be passive cooling, or can be active cooling with flowing cooling gas.

Fig. 6 illustrates an exemplary temperature profile for the furnace shown in Fig. 5. In the loading zone 42, the temperature 42A is set at room temperature, then increases steadily 43A in the ramp up station 43, reaching the diffusion temperature 44A in the steady state zone 44. At the cool down zone 45, the temperature 45A rapidly drops to the ambient temperature 46A at the unloading zone 46.

In an embodiment, the present diffusion furnace comprises a temperature insulation assembly, for example, to maintain temperature uniformity within the hot zone 3 of the diffusion station, which is important in achieving uniform doping profile in the substrates 12. At the entrance and exit, e.g., the loading and unloading station, the temperature is controlled to provide a desired temperature gradient, transitioning to the outside ambient. The temperature is also designed to be uniform along the width of the furnace, especially at the sides of the furnace. Passive insulation, such as fiber glass, can be provided at the sides of the hot zone 3 to ensure temperature uniformity within the diffusion area. Active temperature insulation using heaters can be provided to compensate for the heat loss at the ambient interface.

In an aspect, the furnace 18 employs ceramic rollers 23 as a substrate transport mechanism. The rollers 23 preferably pass through the hot zone 3 to the outside zone so that the rotating mechanism can be located in a cooler area.

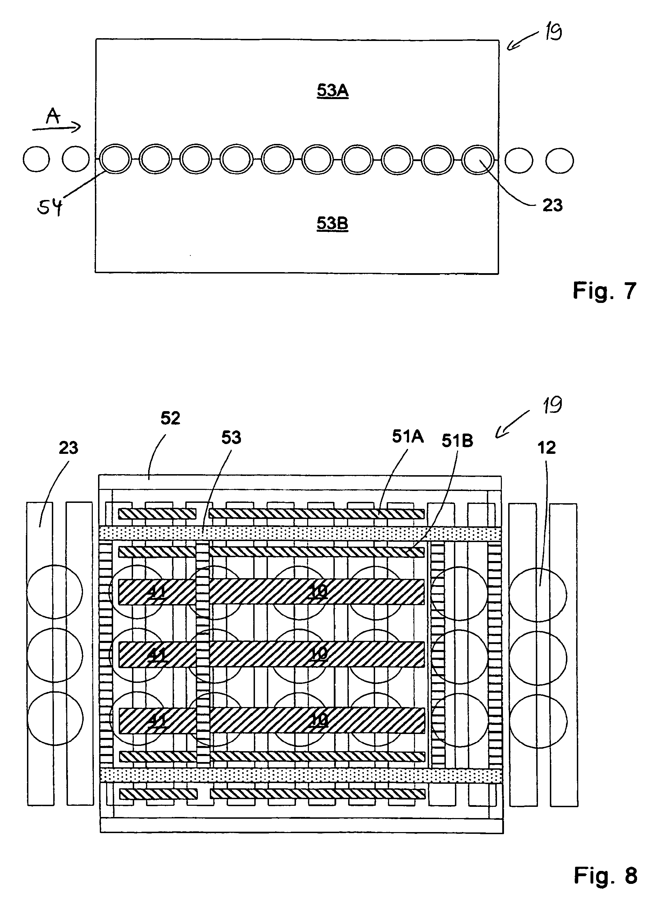

Fig. 7 illustrates a top side wall 53A and a bottom side wall 53B of a furnace 19 according to the present invention, wherein the walls 53A, 53B separate the hot zone 3 and an outside ambient. The side walls 53A, 53B have holes for the rollers 23 to pass through, as shown by the arrow A demonstrating the direction of transportation of substrates 12 through the furnace. In this configuration, the heat loss can be significant through the gaps 54 of the rollers 23 and the walls 53A, 53B. Therefore, the side walls 53A, 53B are isolating side walls to prevent or to minimize a drop of temperature at the sides of the furnace, wherein additional heaters can be provided at the side walls 53A, 53B.

Fig. 8 illustrates the furnace 19 of Fig. 7 with an exemplary active temperature compensation for the heat loss through side heaters 51A and/or 51 B. Heaters 41 are for temperature ramp up, and heaters 10 are for maintaining the diffusion hot zone 3. Rollers 23 pass through the wall 53, and at either or both sides of wall 53 are the active side heaters 51A and 51 B to compensate for the heat loss through the gaps in wall 53. Furnace wall 52 further provides additional insulation to maintain temperature uniformity in the hot zones.

In an embodiment, the diffusion furnace of the present invention comprises a dopant isolation mechanism to isolate the dopant precursor within the diffusion zone and to prevent the dopant from escaping to the outside ambient. The dopant isolation can comprise a pump, a purge, or a pump/purge mechanism at the interface with the outside ambient, such as at the gaps 54 of the rollers 23 and at the loading and unloading stations.

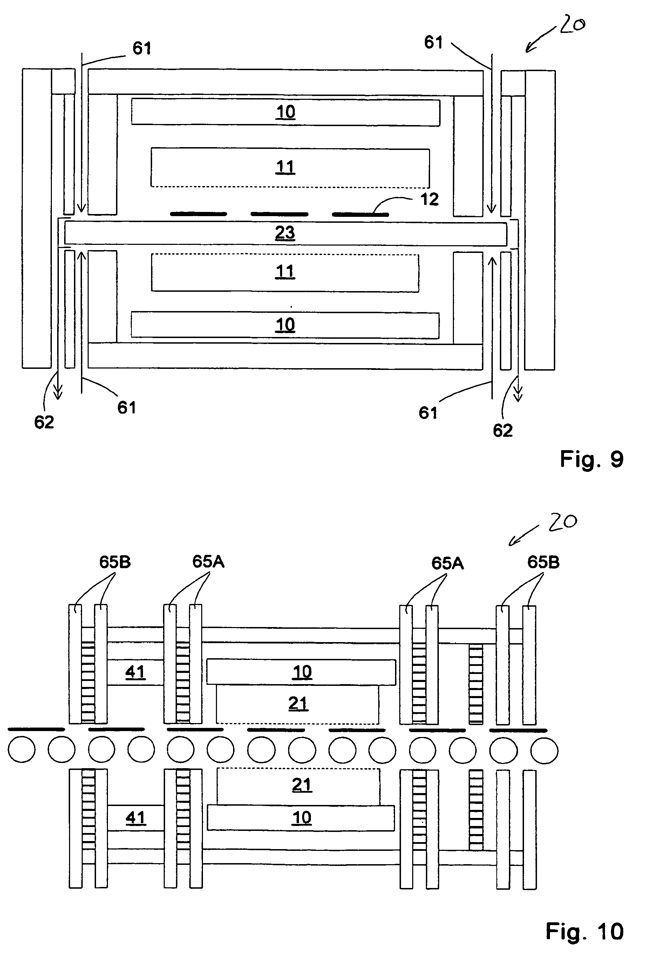

Fig. 9 illustrates a furnace 20 according to a further embodiment of the present invention, with a pump 62 (or exhaust)lpurge 61 assembly at the wall 53, separating the hot zone 3 and the outside wall. The purge 61 can comprise a gas curtain, such as inert or inactive gas. The exhaust 62 can comprise a pumping assembly or an exhaust assembly to exhaust the purge gas together with any dopant released to this area. Similarly, a dopant isolation assembly can be provided at the entrance and exit of the furnace.

Fig. 10 illustrates a dopant isolation assembly 65A to isolate the diffusion hot zone 3, and a dopant isolation assembly 65B to isolate the ramp up station and the cool down station. The dopant isolation assembly 65A and 65B can include a purge gas, an exhaust, or any combination thereof. In addition, the dopant isolation can be positioned either inside, outside or both inside and outside of the zone to be protected.

In an embodiment, the present invention discloses an integrated precursor for simultaneously doping and oxidizing the substrate. The present integrated precursor comprises an oxidation source to provide an oxidation environment for growing an oxide layer on the substrate. The present integrated precursor also comprises a dopant source to dope a dopant layer on the substrate. Thus in an embodiment, the present invention discloses integrated doping/oxidation methods and systems for sequential, overlapping, and/or simultaneous oxidation and doping, where a dopant layer forms on a grown oxide of a substrate.

The oxidation process comprises an oxygen-containing precursor, such as oxygen, ozone, air, and steam, together with applied excitation energy such as IR, heating, and UV. The doping process comprises a dopant precursor, such as phosphorus-containing chemicals (phosphorus acid, phosphine), boron-containing chemicals, or arsenic-containing chemicals. The dopant precursors and the oxidation precursor can be mixed and delivered in vapor or gaseous form, and with or without carrier gas.

The doping and oxidation can occur sequentially, with the doping process occurring before or after the oxidation. For example, the furnace can comprise a section for delivering an oxidation precursor and a section for delivering a dopant precursor, where the substrates can be transported from one section to the other section.

The doping and oxidation process can be overlapped. The oxidation conditions and the dopant coating conditions can be provided next to each other in the same process enclosure, with or without some overlap. The substrate can be stationary, or preferably transported from one end to another end, for example, as in an in-line process, using ceramic rollers or other types of in-line substrate transport. Similarly, the oxidation process can comprise oxidation precursors and excitation energy to promote substrate oxidation. The doping process can comprise any type of dopant layer formation process.

In an embodiment, the present invention discloses system and method for the integrated oxidation and doping process, comprising providing integrated precursors or mixture that can perform both oxidation and doping. For example, the oxidation precursors and the dopant precursors can be selected and mixed under certain conditions before introducing to the substrate. The substrate environment is also subjected to an excitation energy, such as thermal, IR, UV, preferably selected to prevent interference between oxidation and dopant coating.

For example, the integrated precursor can comprise UV/oxygen (such as UV/steam or UV/O₂ or O₃) oxidation and hot phosphorus acid vapor in a showerhead. UV light and thermal energy can be applied to the substrate 10 to promote oxidation, together with oxidation precursors such as steam or oxygen-containing gas. Hot phosphorus acid vapor is also introduced for phosphorus doping in the same hot diffusion zone. The environment conditions can be selected to optimize the oxidation/doping process, preferably to achieve a desired doping profile of phosphorus dopant after a diffusion drive in.

The integrated doping can be performed on both sides of the substrate, or can be applied to only one side (not shown). The substrate can be transported with an in-line transport, such as ceramic rollers 35, or by a dedicated transport mechanism in an isolated processing chamber (not shown). In addition, other components can be implemented, for example, exhaust and isolation to prevent hazardous gas from escaping, temperature isolation to provide wall safety, carrier gas and curtain gas for atmospheric isolation and purging, and substrate conditioning before removal from the process chamber.

In an embodiment, the present invention discloses integrated precursors for an integrated doping/oxidation process, comprising an oxidation precursor for oxidizing a substrate, and a dopant precursor for doping a substrate. The integrated precursors can be selected to perform both oxidation and doping simultaneously with appropriate environment conditions.

In addition to the features of the above exemplarily described furnace 1, 2, 16, 17, 18, 19, 20, an in-line diffusion furnace according to the present invention can comprise: at least one exhaust-channel for a definition of the showerhead 11, 21 or the enclosure 31, and/or an additional purging channel between the showerhead 11, 21 or the enclosure 31 and the exhaust channel; and/or a large-area exhaust under the substrates 12; and/or exhaust strips under the transport assembly; and/or a narrow showerhead between the rollers 23; and/or a showerhead chamber with an intermediate plate for a better distribution of substances in the showerhead 11, 21; and/or phosphoric acid ester (trimethyphosphate or triethylphosphate) as dopant material.

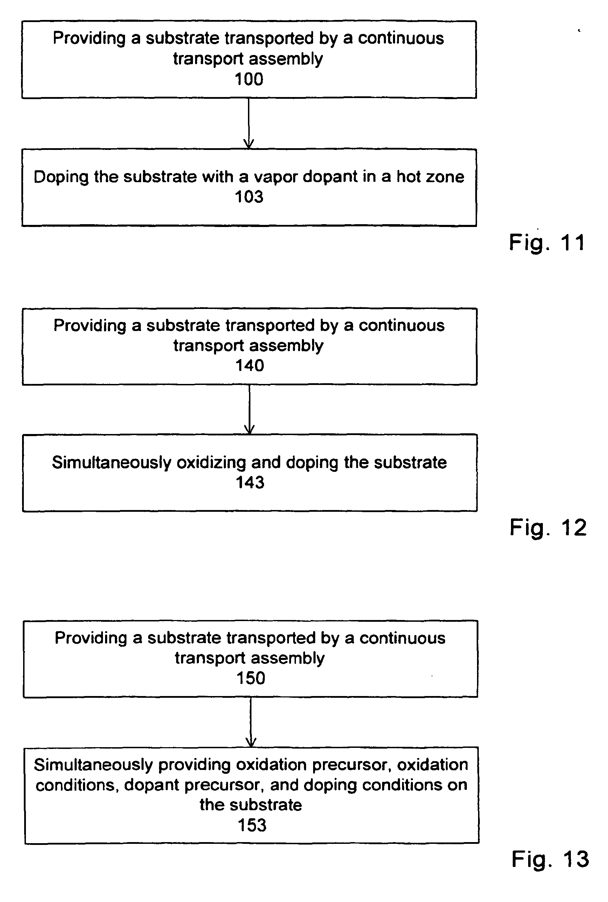

Fig. 11 illustrates another exemplary flowchart for an embodiment of the present in-line diffusion furnace. A substrate is introduced in operation 100, moving continuously by a transport assembly through a hot zone. In operation 103, the substrate is doped in the hot zone by a dopant precursor, for example, delivered to the hot zone through a showerhead.

Fig. 12 illustrates an exemplary flowchart for an embodiment of the present integrated doping/oxidation. A substrate is introduced in operation 140, transported by a continuous transport assembly. In operation 143, the substrate is simultaneously oxidized and doped in a hot zone, utilizing the integrated precursor, which is preferably delivered to the substrate through a showerhead assembly.

Fig. 13 illustrates another exemplary flowchart for an embodiment of the present integrated doper. A substrate is introduced in operation 150, transported by a continuous transport assembly. In operation 153, an oxidation source, oxidation conditions, a dopant source and doping conditions are simultaneously provided to the substrate in a hot zone to grow an oxide and diffusing a dopant layer on the substrate. Alternatively, an integrated precursor comprising an oxidation source and a dopant source can be used, together with applying conditions favorable for oxidizing and doping with minimum interference between the two processes.

## Claims

1. An in-line furnace comprising:
a heater assembly (10) to form a hot zone (3);
a transport assembly (13) for continuously transporting a plurality of substrates (12) through the hot zone (3);
**characterized in**
**that** the in-line furnace is an in-line diffusion furnace (1, 2, 16, 17, 18, 19, 20) for gas phase doping substrates (12), comprising
diffusion chamber (15) and
a dopant delivery assembly for delivering a vapor dopant precursor to the hot zone (3), allowing diffusion of the vapor dopant precursor to the substrates (12),
wherein the dopant delivery assembly comprises means forming a locally defined area in a diffusion area of the diffusion chamber with a defined atmosphere, and
wherein the means forming a locally defined area in a diffusion area of the diffusion chamber (15) with a defined atmosphere comprises at least one showerhead (11, 21) or at least one internal enclosure (31) in the diffusion chamber (15).

2. The in-line diffusion furnace according to claim 1, further comprising a dopant isolation for isolating the dopant precursor, said dopant isolation comprising a purge (61) and an exhaust (62).

3. The in-line diffusion furnace according to at least one of the claims 1 to 2, further comprising at least one additional side heater (51A, 51B) for temperature adjustment at the hot zone (3).

4. The in-line diffusion furnace according to at least one of the claims 1 to 3, wherein the dopant delivery assembly is coupled with means for delivering a vapor mixture of a dopant-containing precursor and an oxygen-containing precursor to the substrates (12) in the hot zone (3).

5. A method for doping substrates (12), **characterized in that** the method comprising:
continuously transporting a plurality of substrates (12) through a hot zone (3) formed by a heater assembly (10) in a diffusion chamber (15) of an in-line diffusion furnace (1, 2, 16, 17, 18, 19, 20);
introducing a dopant precursor by a dopant delivery assembly to the hot zone (3) for doping the substrates (12) passing through the hot zone (3); and
forming a defined atmosphere in a locally defined area in a diffusion area of the diffusion chamber (15) during doping by the dopant delivery assembly,
wherein the defined atmosphere is formed by at least one showerhead (11, 21) or by at least one internal enclosure (31) in the diffusion chamber (15).

6. The method according to claim 5, wherein the dopant precursor is isolated by a dopant isolation, said dopant isolation comprising a purge (61) and an exhaust (62).

7. The method according to at least one of the claims 5 to 6, wherein at least one additional side heater (51 A, 51 B) adjusts temperature at the hot zone (3).

8. The method according to at least one of the claims 5 to 7, wherein the dopant delivery assembly is coupled with means for delivering a vapor mixture of a dopant-containing precursor and an oxygen-containing precursor to the substrates (12) in the hot zone (3).

## Patentansprüche

1. Ein In-Line-Ofen, welcher aufweist:
eine Heizeranordnung (10), um eine heiße Zone (3) auszubilden;
eine Transportanordnung (13) zum kontinuierlichen Transportieren einer Mehrzahl von Substraten (12) durch die heiße Zone (3);
**dadurch gekennzeichnet,**
**dass** der In-Line-Ofen ein In-Line-Diffusionsofen (1, 2, 16, 17, 18, 19, 20) zum Gasphasendotieren von Substraten (12) ist, welcher aufweist Diffusionskammer (15) und
eine Dotantenzulieferanordnung zum Zuliefern eines Gasdotantenprekursors zu der heißen Zone (3), welche eine Diffusion des Gasdotantenprekursors zu den Substraten (12) erlaubt,
wobei die Dotantenzulieferanordnung Mittel aufweist, das oder die einen lokal definierten Bereich in einem Diffusionsgebiet der Diffusionskammer mit einer definierten Atmosphäre ausbildet oder ausbilden, und
wobei das oder die Mittel, das oder die ein lokal definiertes Gebiet in dem Diffusionsgebiet der Diffusionskammer (15) mit einer definierten Atmosphäre ausbildet oder ausbilden, wenigstens eine Dusche (11, 21) oder wenigstens einen internen Einschluss (31) in der Diffusionskammer (15) aufweist oder aufweisen.

2. Der In-Line-Diffusionsofen nach Anspruch 1, welcher weiter eine Dotantenisolation zum Isolieren des Dotantenprekursors aufweist, wobei die Dotantenisolation eine Spülung (61) und eine Absaugung (62) aufweist.

3. Der In-Line-Diffusionsofen nach wenigstens einem der Ansprüche 1 bis 2, welcher weiter wenigstens einen zusätzlichen Seitenheizer (51A, 51 B) zur Temperatureinstellung an der heißen Zone (3) aufweist.

4. Der In-Line-Diffusionsofen nach wenigstens einem der Ansprüche 1 bis 3, wobei die Dotantenzulieferanordnung mit einem Mittel oder Mitteln zum Zuliefern eines Gasgemisches aus einem Dotanten-enthaltenden Prekursor und einem Sauerstoff-enthaltenden Prekursor zu den Substraten (12) in der heißen Zone (3) gekoppelt ist.

5. Ein Verfahren zum Dotieren von Substraten (12), **dadurch gekennzeichnet, dass** das Verfahren aufweist:
kontinuierliches Transportieren einer Mehrzahl von Substraten (12) durch eine heiße Zone (3), die durch eine Heizeranordnung (10) in einer Diffusionskammer (15) eines In-Line-Diffusionsofens (1, 2, 16, 17, 18, 19, 20) ausgebildet ist;
Einbringen eines Dotantenprekursors durch eine Dotantenzulieferanordnung in die heiße Zone (3) zum Dotieren der Substrate (12), die die heiße Zone (3) passieren; und
Ausbilden einer definierten Atmosphäre in einem lokal definierten Gebiet in einem Diffusionsgebiet der Diffusionskammer (15) während des Dotierens durch die Dotantenzulieferanordnung,
wobei die definierte Atmosphäre durch wenigstens eine Dusche (11, 21) oder durch wenigstens einen internen Einschluss (31) in der Diffusionskammer (15) ausgebildet wird.

6. Das Verfahren nach Anspruch 5, wobei der Dotantenprekursor durch eine Dotantenisolation isoliert wird, wobei die Dotantenisolation eine Spülung (61) und eine Absaugung (62) aufweist.

7. Das Verfahren nach wenigstens einem der Ansprüche 5 bis 6, wobei wenigstens ein zusätzlicher Seitenheizer (51A, 51 B) die Temperatur an der heißen Zone (3) einstellt.

8. Das Verfahren nach wenigstens einem der Ansprüche 5 bis 5, wobei die Dotantenzulieferanordnung mit einem Mittel oder Mitteln zum Zuliefern eines Gasgemisches aus einem Dotanten-enthaltenden Prekursor und einem Sauerstoff-enthaltenden Prekursor zu den Substraten (12) in der heißen Zone (3) gekoppelt ist.

## Revendications

1. Un four en ligne comprenant:
un ensemble chauffant (10) pour former une zone chaude (3);
un ensemble de transport (13) pour transporter de façon continue une pluralité de substrats (12) à travers la zone chaude (3);
**caractérisé en ce que**
le four en ligne est un four à diffusion en ligne (1, 2, 16, 17, 18, 19, 20) pour doper en phase gazeuse des substrats (12), comportant la chambre de diffusion (15) et
un ensemble de distribution de dopant pour distribuer un précurseur de dopant en phase vapeur à la zone chaude (3), permettant une diffusion du précurseur de dopant en phase vapeur vers les substrats (12),
l'ensemble de distribution de dopant comportant un moyen formant une zone localement définie dans une zone de diffusion de la chambre de diffusion ayant une atmosphère définie, et
dont ledit moyen formant une zone localement définie dans une zone de diffusion de la chambre de diffusion (15) ayant une atmosphère définie, comporte au moins un pommeau de douche (11, 21) ou au moins une enceinte interne (31) dans la chambre de diffusion (15).

2. Le four à diffusion en ligne suivant la revendication 1, comportant en outre un isolant de dopant pour isoler le précurseur de dopant, ledit isolant de dopant comportant une purge (61) et un échappement (62).

3. Le four à diffusion en ligne suivant au moins l'une des revendications 1 à 2, comportant en outre au moins un élément de chauffage latéral additionnel (51A, 51 B) pour ajuster la température dans la zone chaude (3).

4. Le four à diffusion en ligne suivant au moins l'une des revendications 1 à 3, dont l'ensemble de distribution de dopant étant accouplé à des moyens pour distribuer aux substrats (12) dans la zone chaude (3) une vapeur mélangée d'un précurseur contenant le dopant et d'un précurseur contenant de l'oxygène.

5. Une méthode de dopage de substrats (12), **caractérisée en ce que** la méthode comporte:
le transport continu d'une pluralité de substrats (12) à travers une zone chaude (3) formée par un ensemble chauffant (10) disposé dans une chambre de diffusion (15) d'un four à diffusion en ligne (1, 2, 16, 17, 18, 19, 20) ;
l'introduction d'un précurseur de dopant par un ensemble de distribution de dopant dans la zone chaude (3) pour doper les substrats (12) passant à travers la zone chaude (3) ; et
la formation d'une atmosphère définie dans une zone localement définie dans une zone de diffusion de la chambre de diffusion (15) durant le dopage effectué par l'ensemble de distribution de dopant,
dont l'atmosphère définie étant formée par au moins un pommeau de douche (11, 21) ou par au moins une enceinte interne (31) dans la chambre de diffusion (15).

6. La méthode suivant la revendication 5, dont le précurseur de dopant étant isolé par un isolant de dopant, ledit isolant de dopant comprenant une purge (61) et un échappement (62).

7. La méthode suivant au moins l'une des revendications 5 à 6, avec au moins un élément de chauffage latéral additionnel (51A, 51B) ajustant la température dans la zone chaude (3).

8. La méthode suivant au moins l'une des revendications 5 à 7, dont l'ensemble de distribution de dopant étant accouplé à des moyens pour distribuer aux substrats (12) dans la zone chaude (3) une vapeur mélangée d'un précurseur contenant le dopant et d'un précurseur contenant de l'oxygène.
